# EUROPEAN PATENT SPECIFICATION

(11) **EP 3 844 804 B1**
(45) Date of publication and mention of the grant of the patent: **23.11.2022**
(21) Application number: 19783144.9
(22) Date of filing: 30.08.2019
(51) Int. Cl.: H01L 21/677

(54) **SUBSTRATE PROCESSING APPARATUS AND METHOD FOR PROCESSING SUBSTRATES**
SUBSTRATVERARBEITUNGSVORRICHTUNG UND VERFAHREN ZUR VERARBEITUNG VON SUBSTRATEN
APPAREIL DE TRAITEMENT DE SUBSTRAT ET PROCÉDÉ PERMETTANT DE TRAITER DES SUBSTRATS

(30) Priority: 31.08.2018 NL 2021536
(43) Date of publication of application: 07.07.2021
(73) Proprietor: Levitech B.V., 1322 AP Almere (NL)
(72) Inventor: VAN VELZEN, Wilhelmus Gerardus, 1322 AP Almere (NL); VAN DER WAL, Martijn Gerben, 1322 AP Almere (NL); KUZNETSOV, Vladimir Ivanovich, 1322 AP Almere (NL)
(74) Representative: V.O.
(86) International application number: PCT/NL2019/050557
(87) International publication number: WO 2020/046126

(56) References cited:
- WO-A1-2011/062490
- JP-A- 2008 195 541
- US-A1- 2015 068 867

## Description

### FIELD

The invention relates to a substrate processing apparatus and to a method for processing substrates.

### BACKGROUND

WO20111062490 discloses a substrate processing apparatus comprising a housing which bounds a process tunnel extending in a longitudinal direction and that is configured to accommodate a plurality of substantially flat substrates that, in use are simultaneously transported through the process tunnel in the longitudinal direction. The housing includes an upper wall of which a downwardly directed planar tunnel side bounds an upper side of the process tunnel. The downwardly directed planar tunnel side includes a plurality of gas injection openings through which, in use, gas is injected in the process tunnel for forming an upper gas bearing between each substrate of the plurality of substrates and the upper wall. The housing also includes a lower wall of which an upwardly directed planar side extends parallel to the downwardly directed planar tunnel side and bounds a lower side of the process tunnel. The upwardly directed planar tunnel side also includes a plurality of gas injection openings through which, in use, gas is injected in the process tunnel for forming a lower gas bearing between each substrate of the plurality of substrates and the lower wall. Further, the housing includes two lateral side walls that extend in the longitudinal direction and that bound two lateral sides of the process tunnel. Gas exhaust openings are accommodated in the side walls and open into the process tunnel for exhausting gas from the process tunnel.

WO2011/062490 is primarily directed at preventing collision between the substrates and the side walls by disposing the gas exhaust openings at the side walls in a smart way so that there are not only an upper and a lower gas bearing but, in fact, also two lateral gas bearings.

### SUMMARY

Because of the relatively large upper and lower surface of the substrates, the upper and the lower gas bearing are very stiff, even to such an extend that when a substrate is not entirely flat, e.g. a little warped, it will be flattened by the upper and lower gas bearing. The lateral gas bearings only have the lateral edges of the substrate to exert a force on the substrate. Because in practice, the substrates are thin, typically less than 1 mm, e.g. 150 µm, the lateral surface areas formed by lateral edges of the substrates are very small so that the lateral forces exerted by the lateral gas bearings is also small. In practice, for substrates in the form of square silicon wafers with an edge length of approximately 156 mm and a thickness of 150 µm approximately 3500 substrates/hour can be processed.

It should be noted that the gas layers which form the upper and the lower gas bearing between substrates and the upper and lower wall are very thin. Consequently, the thin gas layers between upper and lower wall on the one hand and the substrate on the other hand exert viscous forces on the substrates that increases proportionally with substrate velocity. In the Levitrack as currently marketed, these viscous forces stabilize the forward substrate velocity to (typically) 0.2-0.3 m/s after travelling a distance of ~ 0.4-0.6 m. The typical length of a Levitrack process tunnel is in the order of 3 -15 m. Consequently, the substrates have a constant substrate velocity over the majority of the process tunnel length. When in this application the term substrate velocity is used, reference is made to the constant substrate velocity which is obtained after the initial acceleration of the substrates in the first meter of the process tunnel.

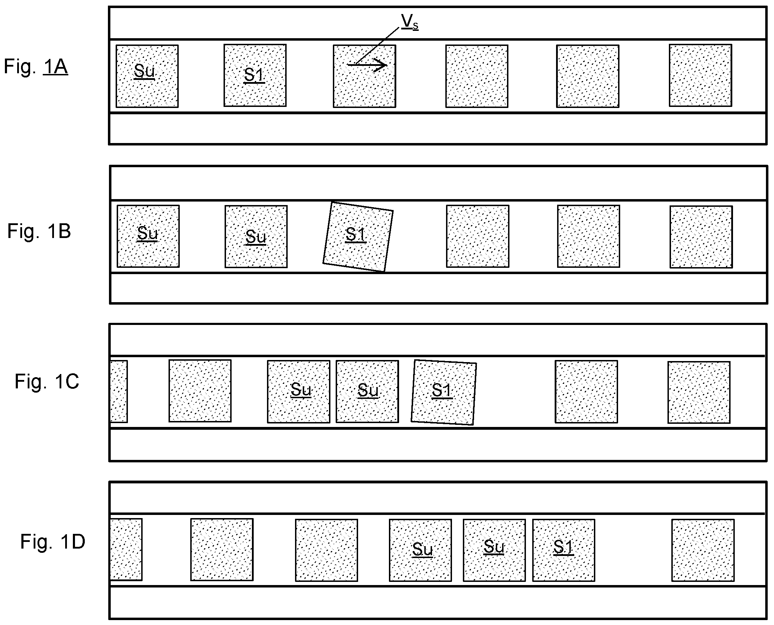

When the transport speed of the substrates is further increased to achieve a higher throughput, e.g. a 50% higher throughput, the inertia forces of the substrates becomes higher and sometimes there is a slight collision or a very light touch between a lateral edge of a substrate and a lateral side wall of the process tunnel. This leads to a slowing down of the touched substrate and an increase of pitch between touched substrate and the substrate downstream of the touched substrate. More importantly, it also leads to a decrease of pitch between the touched substrate and substrate or substrates upstream from the touched substrate. This effect is called bunching and is shown in figures 1A-1D. Fig. 1A shows the substrates at a constant pitch and floating with a substrate velocity Vₛ to the right. Fig. 1B shows that one of the substrates S1 touches a lateral side wall. Fig. 1C shows the reduced pitch between some of the substrates Su upstream of the touched substrate S1. Fig. 1D shows that the touched substrate S1 is again pushed back in line by the lateral gas bearings but that the touched substrate S1 and the upstream substrates Su are "bunched" together. The pick-up assembly which picks up the substrates at the downstream end of the process tunnel has a problem with handling a set of bunched wafers because of the very short time span between the arrival of the subsequent substrates of the bunched set of wafers at the pick-up assembly.

The object of the invention is to solve this problem and thus to provide a substrate processing apparatus that may process more wafers per hour.

To this end, the invention provides a substrate processing apparatus according to claim 1. That is a substrate processing apparatus comprising
- a housing which bounds a process tunnel extending in a longitudinal direction and that is configured to accommodate a plurality of substantially flat substrates that, in use are simultaneously transported through the process tunnel in the longitudinal direction,
wherein the housing includes:
- an upper wall of which a downwardly directed planar tunnel side bounds an upper side of the process tunnel, wherein the downwardly directed planar tunnel side includes a plurality of gas injection openings through which, in use, gas is injected in the process tunnel for forming an upper gas bearing between each substrate of the plurality of substrates and the upper wall;
- a lower wall of which an upwardly directed planar side extends parallel to the downwardly directed planar tunnel side and bounds a lower side of the process tunnel, wherein the upwardly directed planar tunnel side includes a plurality of gas injection openings through which, in use, gas is injected in the process tunnel for forming a lower gas bearing between each substrate of the plurality of substrates and the lower wall;
- two lateral side walls that extend in the longitudinal direction and that bound two lateral sides of the process tunnel;
- gas exhaust openings which are accommodated in one of the above-mentioned walls and that open into the process tunnel for exhausting gas from the process tunnel;
characterized by
- two endless transport belts, wherein each side wall is implemented as a belt part of an associated one of the two endless transport belts; and
- at least one drive for driving the endless transport belts.

When a substrate touches one or both of the transport belts, this does not lead to a slowing down of that substrate because the velocity of the endless transport belts may be substantially the same as the transport velocity of the substrates in the process tunnels. Consequently, the above described problem of bunching of wafers does not occur. It should be noted that the endless transport belts have no function in transporting the substrates through the process tunnel. Normally, there is no contact between the endless transport belt parts that form the side walls and the substrates. Only when, for some reason, one of the substrates would collide or touch one of the belt implemented side walls a short moment of contact is present. This contact has no braking impact on the substrate because the there is no or virtually no speed difference between the substrate and the endless transport belt part. Due to the absence of bunching of substrates, the capacity of the substrate processing apparatus can be increased with at least 50%. The consequence is that the pitch distance between the subsequent substrates remains unaffected. Consequently, a pick-up assembly or pick-up robot at the downstream end of the process tunnel will be regularly supplied with substrates. Not only can the pitch distance between the substrates be kept smaller when feeding the substrates into the process tunnel, the substrate speed may also be increased relative to the known systems because, in fact, the environment of the substrate moves with the same speed in the transport direction as the substrates themselves. Of course, the downwardly directed planar tunnel side formed by the upper wall and the upwardly directed planar tunnel side formed by the lower wall do not move in the transport direction. However, the gas bearings between those sides on the one hand and the substrates on the other hand are so stiff that contact between the substrate and one of the downwardly or upwardly directed planar tunnel sides is impossible.

The invention also provides a method according to claim 13. That is, a method for processing substrates comprising:
- providing a substrate processing apparatus according to the invention;
- intermittently supplying substrates into the process tunnel at an upstream end thereof and intermittently discharging substrates from the process tunnel at a downstream end thereof and simultaneously accommodate a plurality of substantially flat substrates in the process tunnel and floatingly supporting the plurality of substrates with the upper and the lower gas bearings;

- moving each substrate of the plurality of substrates with a substrate transport speed through process tunnel along the longitudinal direction thereof;
- driving the two endless transport belts with a belt speed (V_{b}) so that the belt parts which form the lateral side walls have a belt speed that is substantially the same as the substrate transport speed.

In this context, the substrate speed is the stabilized constant substrate speed which is obtained after the initial acceleration of the substrates in the first meter or so of the process tunnel. Substantially the same means that the belt speed is in the range of 90% to 110% of the constant substrate speed.

By virtue of the fact that the belt parts which form the lateral side walls have a belt speed that is substantially the same as the substrate transport speed, a collision or slight touch between a substrate and one of does not lead to braking of substrate velocity speed. Consequently, the problem of bunching is solved. In view thereof, the pitch distance between the substrates may be reduced and the speed of the substrates may be increased because the substrates are discharged from process tunnel at constant intervals because during processing the pitch distance between the substrates remains constant. Hence, the production capacity of the substrate processing apparatus may be increased. Tests have shown that a production increase of at least 50% is feasible. Relative to the currently marketed Levitrack this means an increase from 3200 to 4800 substrates per hour.

Further embodiments of the invention are claimed in the dependent claims and will be elucidated in the detailed description with reference to an example that is shown in the figures.

### BRIEF DESCRIPTION OF THE FIGURES

Fig. 1 shows top views of the interior of a prior art process tunnel in which substrates float in a transport direction;

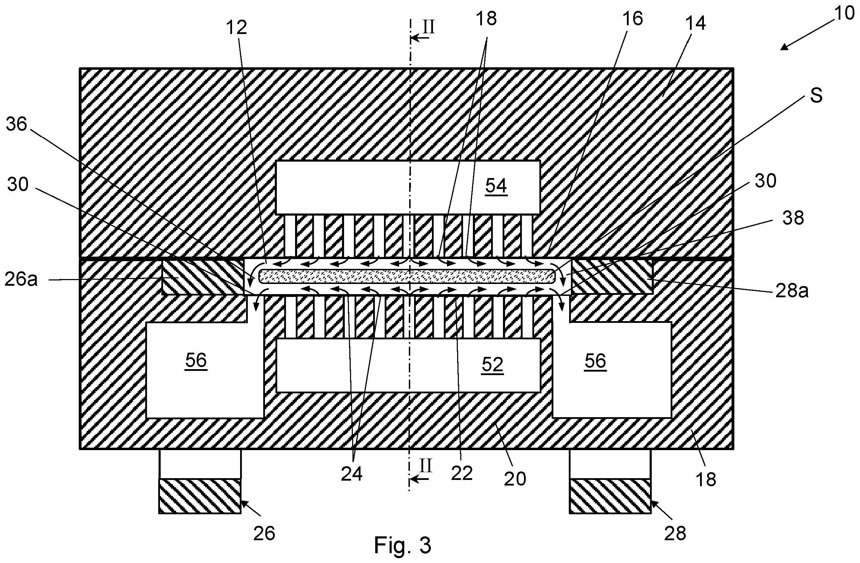

Fig. 2 shows a cross-section along a vertical longitudinal plane along an example of substrate processing apparatus, the plane being indicated with line II-II in figure 3;
Fig. 3 shows a cross section along line III-III in figure 2;
Fig. 4 shows a top view of the substrate processing apparatus with the upper wall being taken away; and
Fig. 5 shows a cross section of the substrate processing apparatus along line V-V in figure 4.

### DETAILED DESCRIPTION

In the detailed description various embodiments are described which may be combined and which may be applied independently of each other. The reference numbers in the detailed description refer to the example shown in the figures. The invention and the further embodiments thereof are not limited to the example shown in the drawings. In fact, the reference numbers in the detailed description do not limit this detailed description. The reference numbers mentioned in the claims do not limit the claims either.

The invention relates to substrate processing apparatus 10 which comprises a housing which bounds a process tunnel 12 extending in a longitudinal direction. The process tunnel 12 is configured to accommodate a plurality of substantially flat substrates S that, in use are simultaneously transported through the process tunnel 12 in the longitudinal direction. The housing includes an upper wall 14 of which a downwardly directed planar tunnel side 16 bounds an upper side of the process tunnel 12. The downwardly directed planar tunnel side 16 includes a plurality of gas injection openings 18 through which, in use, gas is injected in the process tunnel 12 for forming an upper gas bearing between each substrate S of the plurality of substrates and the upper wall 14. The housing additionally includes a lower wall 20 of which an upwardly directed planar side 22 extends parallel to the downwardly directed planar tunnel side 16 and bounds a lower side of the process tunnel 12. The upwardly directed planar tunnel side 22 includes a plurality of gas injection openings 24 through which, in use, gas is injected in the process tunnel 12 for forming a lower gas bearing between each substrate S of the plurality of substrates and the lower wall 20. The housing further includes two lateral side walls 26a, 28a that extend in the longitudinal direction and that bound two lateral sides of the process tunnel 12. Finally, gas exhaust openings 30 are provided which are accommodated in one of the above-mentioned walls and which open into the process tunnel 12 for exhausting gas from the process tunnel 12.

According to the invention, the substrate processing apparatus 10 comprises two endless transport belts 26, 28. In fact, each side wall is implemented as a belt part 26a, 26b of an associated one of the two endless transport belts 26, 28. Additionally, the substrate processing apparatus 10 comprises at least one drive 32 for driving the endless transport belts 26, 28.

The advantages which are obtained with the substrate processing apparatus 10 according to the invention are described in the summary to which reference is made here.

In an embodiment, of which an example is shown in the figures, the substrate processing apparatus may comprise an electronic controller 34 which is configured to control a transport direction and transport speed of each endless transport belt 26, 28 such that, in use, the transport speed and transport direction of the two endless transport belt parts 26a, 28a that each form a lateral side wall are substantially the same as a transport speed and transport direction of the plurality of substrates S that are moving through the process tunnel 12 in the longitudinal direction.

With such an electronic controller, the belt speed V_{b} may be adapted to the substrate transport speed Vₛ. This may be of importance when the stabilized, constant substrate transport speed Vₛ which is obtained after an initial acceleration phase in the first meter or so of the process tunnel 12, may be different for different batches of substrates. This can be the case when the substrates of subsequent batches have different properties, e.g. different weights. It may also be the case for a substrate processing apparatus 10 which has a variable pressure drive or a variable gravity drive. The pressure drive and gravity drive will be described in more detail below.

In an embodiment, the endless transport belts 26, 28 may be fiber reinforced polytetrafluoroethylene transport belts. Polytetrafluoroethylene is rather heat resistant and can withstand temperatures of 200°C without any problems.

In an embodiment, the fibers may be chosen from the group consisting of glass fibers, carbon fibers and aramid fibers. Glass and carbon fibers are preferred because of their heat resistance and because of the relatively low costs.

In an alternative embodiment, each endless transport belt 26, 28 may comprise a closed loop metal band.

Metal band has an excellent durability.

In an embodiment, the metal may be stainless steel.

In a further elaboration of this embodiment, the closed loop metal band may be coated with a polytetrafluoroethylene coating. Thus the thickness of the metal band may be kept low so that an optimal flexibility remains.

In an embodiment, of which an example is shown in the figures, the gas exhaust openings 30 may positioned in the upwardly directed planar tunnel side 22 in two lateral areas 36, 38 that extend along the length of the process tunnel 12. Alternatively or additionally, the gas exhaust openings 30 may be positioned in the downwardly directed planar tunnel side 16 in the two lateral areas 36, 38 that extend along the length of the process tunnel. Each lateral areas 36, 38 is bounded by an associated one of the two belt parts 26a, 28a of the two endless transport belts 26, 28 that form the side walls. In this embodiment, the gas injection openings 18, 24 are positioned between the two lateral areas 36, 38, so that, in use, gas injected in the process tunnel 12 via the gas injection openings 18, 24 flows substantially laterally to the lateral areas 36, 38 and is exhausted via the gas exhaust openings 30.

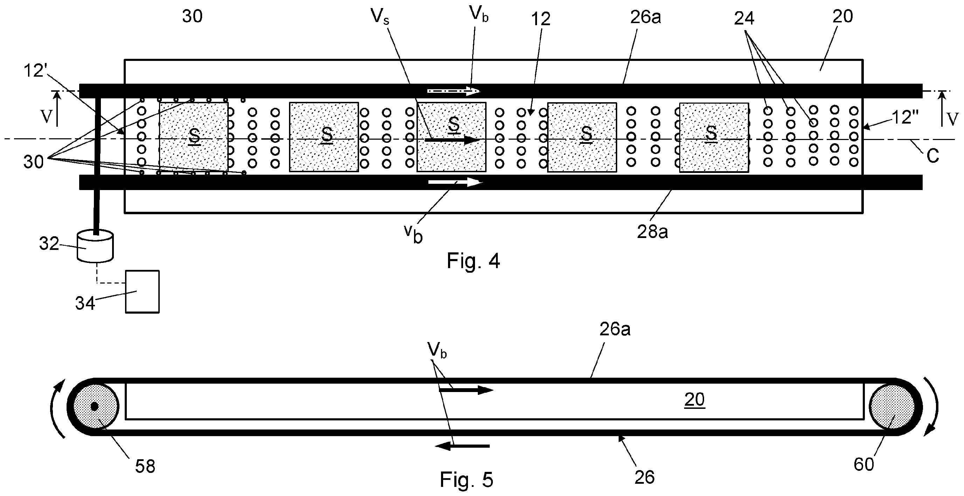

In the closest prior art that is discussed in the background section, the gas exhaust openings are disposed in the side walls. By placing the gas exhaust openings 30 in the stationary downwardly directed and/or downwardly directed planar tunnel sides 16, 22, the gas exhaust openings remain stationary which is highly beneficial from a constructional point of view. In figure 4, the laterally disposed gas exhaust openings 30 are only shown in the upstream part of the process tunnel 12. However, it is clear that these gas exhaust openings 30 are provided along the entire length of the process tunnel 12.

In a further elaboration of this embodiment, the lateral areas 36, 38 each have a lateral width of less than 2 mm.

By making the lateral width of the lateral areas 36, 38 small, an effective lateral gas bearing may be obtained.

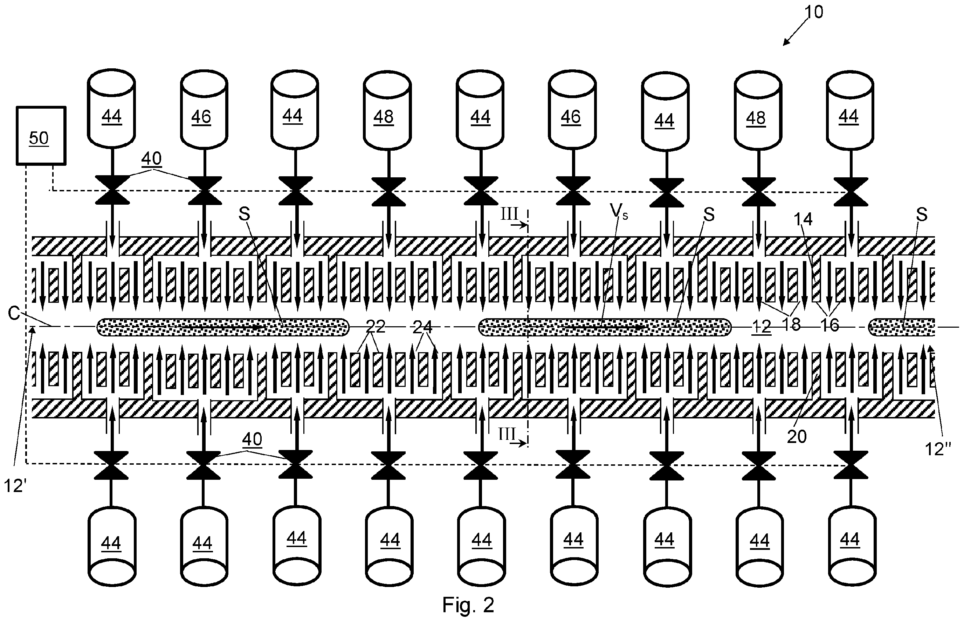

In an embodiment, of which an example is shown in figure 2, substrate processing apparatus 10 may include a plurality of control valves 40 via which the gas injection openings 18, 24 are connectable to gas sources 44, 46, 48. In the example shown in figure 2, the gas source having reference number 44 may be an inert gas such as N₂. The gas source having reference number 46 may be a first precursor gas such as TMA (trimethylaluminium). The gas source having reference number 48 may be second precursor gas such as H₂O. With this combination, an atomic layer deposition may be executed to form an Al₂O₃-layer. In the example shown in figure 2, the atomic layer deposition is effected on the upper side of the substrates S. The lower sides of the substrates are not processed but are simply supported by a gas bearing, formed from inert gas, such as N₂. It is clear that the ALD can alternatively be effected on the lower side of the substrates and that in that case the upper sides of the substrates are not processed but simply supported by a gas bearing. Additionally, the shown example is also fit for performing ALD on both sides of the substrates. For that, the gas source arrangement shown in the upper half of the figure should also be provided in the lower half of the figure instead of the inert gas sources 44 which are now shown in the lower half of figure 2. Instead of atomic layer deposition, other substrate processing may be performed, e.g. annealing with inert gas, whereby the upper and or lower walls 14, 20 may be heated. Also other CVD processes are possible instead of the ALD-process described above by way of example.

In that embodiment, the control valves 40 may be operatively connected to an electronic controller 50. With the control valves 40 the amount of gas that is supplied may be controlled. In that manner, the average gas pressure in the process tunnel may be controlled, for example such that the average gas pressure gradually diminishes when going from an upstream end 12' to a downstream end 12" of the process tunnel. Such a decreasing pressure profile provides a pressure drive. That is, the substrate velocity Vₛ may be controlled by controlling the pressure profile along the length of the process tunnel 12. In this manner, the substrate velocity Vₛ may also varied by simply varying the pressure profile along the length of the process tunnel 12.

In an embodiment, the process tunnel 12 may include a plurality of longitudinal sections. Each longitudinal section extends laterally over the entire width of the process tunnel 12 and over a part of the length of the process tunnel 12. Each longitudinal section may be defined by the gas injection openings 18, 24 in the upwardly directed side and/or downwardly directed side that are connected via one of the plurality of control valves 40 to one of said gas sources 44, 46, 48. In this embodiment, the electronic controller 50 that is operatively connected to the control valves 44, 46, 48 may be configured for controlling the control valves 44, 46, 48 to establish an average gas pressure in each longitudinal section of the process tunnel 12. With such an embodiment, the pressure profile along the length of the process tunnel 12 can be very accurately controlled.

In an embodiment, the electronic controller 50 may be configured for controlling the control valves 40 to establish an average gas pressure in each longitudinal section of the process tunnel 12 so that the average gas pressure in the process tunnel 12 gradually decreases from a first average gas pressure at an upstream longitudinal end 12' of the process tunnel to a second average gas pressure at downstream longitudinal end 12" of the process tunnel. The first average gas pressure is higher than the second average gas pressure. When such a pressure profile is established along the length of the process tunnel 12, a pressure drive is created. The substrates S float to the downstream end 12" of the process tunnel 12 in which the average pressure is smallest. With such a pressure drive, a very precise control of the substrate velocity Vₛ can be obtained. It should be noted that pressure drive is extensively described in WO2012/005577.

In embodiment, which may be an alternative for the pressure drive or which may be applied in combination with the pressure drive configuration, gravity may be used to propel the substrates from an upstream end 12' to a downstream end 12" of the process tunnel 12. The process tunnel 12 defines process tunnel center line C, which extends at equal distances to the two side walls 26a, 28a and at equal distances to the downwardly directed planar tunnel side 16 and the upwardly directed planar tunnel side 22. The housing is disposed such that the process tunnel center line C includes a slight angle α with a horizontal plane such that an upstream end 12' of the process tunnel 12 is at a higher level than a downstream end 12" of the process tunnel 12. The slight angle α may be between 0° to 5°. This type of gravity drive is extensively described in WO2009/142487. The substrate velocity Vₛ may be varied by varying the angle α. It is clear that a steeper angle will lead to a higher substrate velocity Vₛ.

The invention also relates to a method for processing substrates S. the method comprises providing a substrate processing apparatus 10 according to the invention. The method additionally comprises:
- intermittently supplying substrates S into the process tunnel 12 at an upstream end 12' thereof and intermittently discharging substrates S from the process tunnel 12 at a downstream end 12" thereof and simultaneously accommodating a plurality of substantially flat substrates S in the process tunnel 12 and floatingly supporting the plurality of substrates S with the upper and the lower gas bearings;
- moving each substrate S of the plurality of substrates with a substrate transport speed Vₛ through process tunnel 12 along the longitudinal direction thereof; and
- driving the two endless transport belts 26, 28 with a belt speed V_{b} so that the belt parts 26a, 28a which form the lateral side walls have a belt speed V_{b} that is substantially the same as the substrate transport speed Vₛ.

The advantages of the method are already described above in the summary section. This part of the description is inserted here by reference.

The invention is not limited to the example shown in the drawings but is defined by the appended claims. Reference numbers used in the detailed description and the claims do not limit these parts of the disclosure.

## Claims

1. A substrate processing apparatus (10) comprising
• a housing which bounds a process tunnel (12) extending in a longitudinal direction and that is configured to accommodate a plurality of substantially flat substrates that, in use are simultaneously transported through the process tunnel in the longitudinal direction,
wherein the housing includes:
• an upper wall (14) of which a downwardly directed planar tunnel side (16) bounds an upper side of the process tunnel, wherein the downwardly directed planar tunnel side (16) includes a plurality of gas injection openings (18) through which, in use, gas is injected in the process tunnel (12) for forming an upper gas bearing between each substrate (S) of the plurality of substrates and the upper wall (14);
• a lower wall (20) of which an upwardly directed planar side (22) extends parallel to the downwardly directed planar tunnel side (16) and bounds a lower side of the process tunnel (12), wherein the upwardly directed planar tunnel side (22) includes a plurality of gas injection openings (24) through which, in use, gas is injected in the process tunnel (12) for forming a lower gas bearing between each substrate (S) of the plurality of substrates and the lower wall (20);
• two lateral side walls (26a, 28a) that extend in the longitudinal direction and that bound two lateral sides of the process tunnel (12);
• gas exhaust openings (30) which are accommodated in one of the above-mentioned walls and that open into the process tunnel (12) for exhausting gas from the process tunnel (12);
**characterized by**
• two endless transport belts (26, 28), wherein each side wall is implemented as a belt part (26a, 26b) of an associated one of the two endless transport belts (26, 28); and
• at least one drive (32) for driving the endless transport belts (26, 28).

2. The substrate processing apparatus according to claim 1, comprising:
• an electronic controller (34) which is configured to control a transport direction and transport speed of each endless transport belt (26, 28) such that, in use, the transport speed and transport direction of the two endless transport belt parts (26a, 28a) that each form a lateral side wall are substantially the same as a transport speed and transport direction of the plurality of substrates (S) that are moving through the process tunnel (12) in the longitudinal direction.

3. The substrate processing apparatus according to claim 1 or 2, wherein the endless transport belts (26, 28) are fiber reinforced polytetrafluoroethylene transport belts.

4. The substrate processing apparatus according to claim 3, wherein the fibers are chosen from a group consisting of glass fibers, carbon fibers and aramid fibers.

5. The substrate processing apparatus according to claim 1 or 2, wherein each endless transport belt (26, 28) comprises a closed loop metal band.

6. The substrate processing apparatus according to claim 5, wherein the metal band is a stainless steel band.

7. The substrate processing apparatus according to claim 5 or 6, wherein the closed loop metal band is coated with a polytetrafluoroethylene coating.

8. The substrate processing apparatus according to any one of claims 1-7, wherein the gas exhaust openings (30) are positioned in the downwardly directed planar tunnel side (16) and/or in the upwardly directed planar tunnel side (22) in two lateral areas (36, 38) that extend along the length of the process tunnel (12), wherein the each lateral area (36, 38) is bounded by an associated one of the two belt parts (26a, 28a) of the two endless transport belts (26, 28) that form the side walls, wherein the gas injection openings (18, 24) are positioned between the two lateral areas (36, 38), so that, in use, gas injected in the process tunnel (12) via the gas injection openings (18, 24) flows substantially laterally to the lateral areas (36, 38) and is exhausted via the gas exhaust openings (30).

9. The substrate processing apparatus according to claim 8, wherein the lateral areas (36, 38) each have a lateral width of less than 2 mm.

10. The substrate processing apparatus according to any one of claims 1-9, comprising:
• a plurality of control valves (40) via which the gas injection openings (18, 24) are connectable to gas sources (44, 46, 48);
• an electronic controller (50) that is operatively connected to the control valves (40);
wherein the process tunnel (12) includes a plurality of longitudinal sections, wherein each longitudinal section extends laterally over the entire width of the process tunnel (12) and over a part of the length of the process tunnel (12), wherein each longitudinal section is defined by the gas injection openings (18, 24) in the upwardly directed planar tunnel side (22) and/or downwardly directed planar tunnel side (16) that are connected via one of the plurality of control valves (40) to one of said gas sources (44, 46, 48),
wherein the electronic controller (50) that is operatively connected to the control valves (44, 46, 48) is configured for controlling the control valves (44, 46, 48) to establish an average gas pressure in each longitudinal section of the process tunnel (12).

11. The substrate processing apparatus according to claim 10, wherein the electronic controller (50) that is operatively connected to the control valves (40) is configured for controlling the control valves (40) to establish an average gas pressure in each longitudinal section of the process tunnel (12) so that the average gas pressure in the process tunnel (12) gradually decreases from a first average gas pressure at an upstream longitudinal end (12') of the process tunnel to a second average gas pressure at downstream longitudinal end (12") of the process tunnel, wherein the first average gas pressure is higher than the second average gas pressure.

12. The substrate processing apparatus according to any one of claims 1-11, wherein a process tunnel center line (C) is defined by a line that extends at equal distances to the two side walls (26a, 28a) and at equal distances to the downwardly directed planar tunnel side (16) and the upwardly directed planar tunnel side (22), wherein the housing is disposed such that the process tunnel center line (C) includes an slight angle (α) with a horizontal plane such that an upstream end of the process tunnel is at a higher level than a downstream end of the process tunnel, wherein the slight angle (α) is between 0° to 5°.

13. A method for processing substrates comprising:
• providing a substrate processing apparatus (10) according to any one of claims 1-12;
• intermittently supplying substrates (S) into the process tunnel (12) at an upstream end (12') thereof and intermittently discharging substrates (S) from the process tunnel (12) at a downstream end (12") thereof and simultaneously accommodating a plurality of substantially flat substrates (S) in the process tunnel (12) and floatingly supporting the plurality of substrates (S) with the upper and the lower gas bearings;
• moving each substrate (S) of the plurality of substrates with a substrate transport speed (Vₛ) through process tunnel (12) along the longitudinal direction thereof;
• driving the two endless transport belts (26, 28) with a belt speed (V_{b}) so that the parts (26a, 28a) which form the lateral side walls have a belt speed (V_{b}) that is substantially the same as the substrate transport speed (Vₛ).

## Patentansprüche

1. Substratbearbeitungseinrichtung (10) mit
• einem Gehäuse, das einen Bearbeitungstunnel (12) begrenzt, der sich in Längsrichtung erstreckt, und ausgebildet ist, um mehrere im Wesentlichen flache Substrate aufzunehmen, die im Gebrauch gleichzeitig in Längsrichtung durch den Bearbeitungstunnel transportiert werden,
wobei das Gehäuse aufweist:
• eine obere Wand (14), von der eine nach unten gerichtete ebene Tunnelseite (16) eine obere Seite des Bearbeitungstunnels begrenzt, wobei die nach unten gerichtete ebene Tunnelseite (16) mehrere Gasinjektionsöffnungen (18) aufweist, durch die im Gebrauch, Gas in den Bearbeitungstunnel (12) injiziert wird, um ein oberes Gaslager zwischen jedem Substrat (S) der mehreren Substrate und der oberen Wand (14) zu bilden;
• eine untere Wand (20), von der eine nach oben gerichtete ebene Seite (22) parallel zu der nach unten gerichteten ebenen Tunnelseite (16) gerichtet ist und eine untere Seite des Bearbeitungstunnels (12) begrenzt, wobei die nach oben gerichtete ebene Tunnelseite (22) mehrere Gasinjektionsöffnungen (24) aufweist, durch die im Gebrauch Gas in den Bearbeitungstunnel (12) injiziert wird, um ein unteres Gaslager zwischen jedem Substrat (S) der mehreren Substrate und der unteren Wand (20) zu bilden;
• zwei seitliche Seitenwände (26a, 28a), die sich in Längsrichtung erstrecken und zwei seitliche Seiten des Bearbeitungstunnels (12) begrenzen;
• Gasabzugsöffnungen (30), die in einer der vorgenannten Wände aufgenommen sind und in den Bearbeitungstunnel (12) münden, um Gas aus dem Bearbeitungstunnel (12) abzuziehen;
**gekennzeichnet durch**
• zwei endlose Transportbänder (26, 28), wobei jede Seitenwand als Bandteil (26a, 26b) eines zugehörigen der zwei endlosen Transportbänder (26, 28) ausgeführt ist; und
• wenigstens einen Antrieb (32) zum Antreiben der endlosen Transportbänder (26, 28).

2. Substratbearbeitungseinrichtung nach Anspruch 1, umfassend:
• eine elektronische Steuerung (34), die so eingerichtet ist, dass sie eine Transportrichtung und eine Transportgeschwindigkeit jedes endlosen Transportbandes (26, 28) so steuert, dass im Gebrauch die Transportgeschwindigkeit und die Transportrichtung der beiden endlosen Transportbandteile (26a, 28a), die jeweils eine seitliche Seitenwand bilden, im Wesentlichen dieselben sind wie eine Transportgeschwindigkeit und eine Transportrichtung der mehreren Substrate (S), die sich in der Längsrichtung durch den Bearbeitungstunnel (12) bewegen.

3. Substratbearbeitungseinrichtung nach Anspruch 1 oder 2, wobei die endlosen Transportbänder (26, 28) faserverstärkte Polytetrafluorethylen-Transportbänder sind.

4. Substratbearbeitungseinrichtung nach Anspruch 3, wobei die Fasern aus einer Gruppe ausgewählt sind, die aus Glasfasern, Kohlenstofffasern und Aramidfasern besteht.

5. Substratbearbeitungseinrichtung nach Anspruch 1 oder 2, wobei jedes endlose Transportband (26, 28) ein Metallband mit geschlossener Schleife umfasst.

6. Substratbearbeitungseinrichtung nach Anspruch 5, wobei das Metallband ein Band aus rostfreiem Stahl ist.

7. Substratbearbeitungseinrichtung nach Anspruch 5 oder 6, wobei das Metallband mit geschlossener Schleife mit einer Polytetrafluorethylen-Beschichtung beschichtet ist.

8. Substratbearbeitungseinrichtung nach einem der Ansprüche 1 bis 7, wobei die Gasabzugsöffnungen (30) in der nach unten gerichteten ebenen Tunnelseite (16) und/oder in der nach oben gerichteten ebenen Tunnelseite (22) in zwei seitlichen Bereichen (36, 38) positioniert sind, die sich über die Länge des Bearbeitungstunnels (12) erstrecken, wobei jeder seitliche Bereich (36, 38) von einem zugehörigen der zwei Bandteile (26a, 28a) der zwei endlosen Transportbänder (26, 28), die die Seitenwände bilden, begrenzt wird, wobei die Gasinjektionsöffnungen (18, 24) zwischen den beiden seitlichen Bereichen (36, 38) positioniert sind, so dass im Gebrauch über die Gasinjektionsöffnungen (18, 24) in den Bearbeitungstunnel (12) eingeblasenes Gas im Wesentlichen seitlich zu den seitlichen Bereichen (36, 38) strömt und über die Gasabzugsöffnungen (30) abgezogen wird.

9. Substratbearbeitungseinrichtung nach Anspruch 8, wobei die seitlichen Bereiche (36, 38) jeweils eine seitliche Breite von weniger als 2 mm aufweisen.

10. Substratbearbeitungseinrichtung nach einem der Ansprüche 1 bis 9, umfassend:
• mehrere Steuerventile (40), über die die Gaseinspritzöffnungen (18, 24) mit Gasquellen (44, 46, 48) verbunden werden können;
• eine elektronische Steuerung (50), das betriebsmäßig mit den Steuerventilen (40) verbunden ist;
wobei der Bearbeitungstunnel (12) mehrere Längsabschnitte aufweist, wobei sich jeder Längsabschnitt seitlich über die gesamte Breite des Bearbeitungstunnels (12) und über einen Teil der Länge des Bearbeitungstunnels (12) erstreckt, wobei jeder Längsabschnitt durch die Gasinjektionsöffnungen (18, 24) in der nach oben gerichteten ebenen Tunnelseite (22) und/oder der nach unten gerichteten ebenen Tunnelseite (16) definiert ist, die über eines der mehreren Steuerventile (40) mit einer der Gasquellen (44, 46, 48) verbunden sind,
wobei die elektronische Steuerung (50), die betriebsmäßig mit den Steuerventilen (44, 46, 48) verbunden ist, für die Steuerung der Steuerventile (44, 46, 48) eingerichtet ist, um einen durchschnittlichen Gasdruck in jedem Längsabschnitt des Bearbeitungstunnels (12) herzustellen.

11. Substratbearbeitungseinrichtung nach Anspruch 10, wobei die elektronische Steuerung (50), die betriebsmäßig mit den Steuerventilen (40) verbunden ist, so eingerichtet ist, dass sie die Steuerventile (40) so steuert, dass ein durchschnittlicher Gasdruck in jedem Längsabschnitt des Bearbeitungstunnels (12) aufgebaut wird, so dass der durchschnittliche Gasdruck im Bearbeitungstunnel (12) allmählich von einem ersten durchschnittlichen Gasdruck an einem stromaufwärts gelegenen Längsende (12') des Bearbeitungstunnels auf einen zweiten durchschnittlichen Gasdruck am stromabwärts gelegenen Längsende (12") des Bearbeitungstunnels abnimmt, wobei der erste durchschnittliche Gasdruck höher ist als der zweite durchschnittliche Gasdruck.

12. Substratbearbeitungseinrichtung nach einem der Ansprüche 1 bis 11, wobei eine Bearbeitungstunnel-Mittellinie (C) durch eine Linie definiert ist, die sich in gleichen Abständen zu den beiden Seitenwänden (26a, 28a) und in gleichen Abständen zu der nach unten gerichteten ebenen Tunnelseite (16) und der nach oben gerichteten ebenen Tunnelseite (22) erstreckt, wobei das Gehäuse so angeordnet ist, dass die Bearbeitungstunnel-Mittellinie (C) einen leichten Winkel (a) mit einer horizontalen Ebene einschließt, so dass ein stromaufwärts gelegenes Ende des Bearbeitungstunnels auf einem höheren Niveau liegt als ein stromabwärts gelegenes Ende des Bearbeitungstunnels, wobei der leichte Winkel (a) zwischen 0° und 5° beträgt.

13. Verfahren zur Bearbeitung von Substraten, umfassend:
• Bereitstellen einer Substratbearbeitungseinrichtung (10) nach einem der Ansprüche 1 bis 12;
• intermittierendes Zuführen von Substraten (S) in den Bearbeitungstunnel (12) an einem stromaufwärtigen Ende (12') davon und intermittierendes Austragen von Substraten (S) aus dem Bearbeitungstunnel (12) an einem stromabwärtigen Ende (12") davon und gleichzeitiges Aufnehmen mehrerer im Wesentlichen flachen Substrate (S) in dem Bearbeitungstunnel (12) und schwimmendes Tragen der mehreren Substraten (S) mit dem oberen und dem unteren Gaslager;
• Bewegen jedes Substrats (S) der mehreren Substrate mit einer Substrattransportgeschwindigkeit (Vₛ) durch den Bearbeitungstunnel (12) entlang der Längsrichtung davon;
• Antreiben der zwei endlosen Transportbänder (26, 28) mit einer Bandgeschwindigkeit (V_{b}), so dass die Teile (26a, 28a), die die seitlichen Seitenwände bilden, eine Bandgeschwindigkeit (V_{b}) aufweisen, die im Wesentlichen gleich der Substrattransportgeschwindigkeit (Vₛ) ist.

## Revendications

1. Appareil de traitement de substrat (10) comprenant
• un boîtier qui lie un tunnel de procédé (12) s'étendant dans une direction longitudinale et qui est configuré pour loger plusieurs substrats substantiellement plats qui, dans une utilisation sont simultanément transportés à travers le tunnel de procédé dans la direction longitudinale,
dans lequel le boîtier inclut :
• une paroi supérieure (14) dont un côté de tunnel plan dirigé vers le bas (16) se lie à un côté supérieur du tunnel de procédé, dans lequel le côté de tunnel plan dirigé vers le bas (16) inclut plusieurs ouvertures d'injection de gaz (18) à travers lesquelles, lors de l'utilisation, du gaz est injecté dans le tunnel de procédé (12) pour former un support de gaz supérieur entre chaque substrat (S) des plusieurs substrats et la paroi supérieure (14) ;
• une paroi inférieure (20) dont un côté plan dirigé vers le haut (22) s'étend parallèlement au côté de tunnel plan dirigé vers le bas (16) et se lie à un côté inférieur du tunnel de procédé (12), dans lequel le côté de tunnel plan dirigé vers le haut (22) inclut plusieurs ouvertures d'injection de gaz (24) à travers lesquelles, lors de l'utilisation, du gaz est injecté dans le tunnel de procédé (12) pour former un support de gaz inférieur entre chaque substrat (S) des plusieurs substrats et la paroi inférieure (20) ;
• deux parois de côtés latéraux (26a, 28a) qui s'étendent dans la direction longitudinale et qui lient deux côtés latéraux du tunnel de procédé (12) ;
• des ouvertures d'échappement de gaz (30) qui sont logées dans une des parois citées ci-dessus et qui s'ouvrent dans le tunnel de procédé (12) pour faire échapper du gaz du tunnel de procédé (12) ;
**caractérisé par**
• deux courroies de transport sans fin (26, 28), dans lequel chaque paroi latérale est réalisée comme une partie de courroie (26a, 26b) d'une associée des deux courroies de transport sans fin (26, 28) ; et
• au moins une commande (32) pour commander les courroies de transport sans fin (26, 28).

2. Appareil de traitement de substrat selon la revendication 1, comprenant
: •un dispositif de contrôle électronique (34) qui est configuré pour contrôler une de transport sans fin (26a, 28a) qui forment chacune une paroi de côté latéral sont substantiellement identiques à une vitesse de transport et direction de transport des plusieurs substrats (S) qui se déplacent à travers le tunnel de procédé (12) dans la direction longitudinale.

3. Appareil de traitement de substrat selon la revendication 1 ou 2, dans lequel les courroies de transport sans fin (26, 28) sont des courroies de transport en polytétrafluoroéthylène renforcé par des fibres.

4. Appareil de traitement de substrat selon la revendication 3, dans lequel les fibres sont choisies dans un groupe consistant en fibres de verre, fibres de carbone et fibres d'aramide.

5. Appareil de traitement de substrat selon la revendication 1 ou 2, dans lequel chaque courroie de transport sans fin (26, 28) comprend une bande en métal à boucle fermée.

6. Appareil de traitement de substrat selon la revendication 5, dans lequel la bande en métal est une bande en acier inoxydable.

7. Appareil de traitement de substrat selon la revendication 5 ou 6, dans lequel la bande en métal à boucle fermée est revêtue avec un revêtement de polytétrafluoroéthylène.

8. Appareil de traitement de substrat selon l'une quelconque des revendications 1-7, dans lequel les ouvertures d'échappement de gaz (30) sont positionnées dans le côté de tunnel plan dirigé vers le bas (16) et/ou dans le côté de tunnel plan dirigé vers le haut (22) dans deux zones latérales (36, 38) qui s'étendent le long de la longueur du tunnel de procédé (12), dans lequel chaque zone latérale (36, 38) est liée par une associée des deux parties de courroies (26a, 28a) des deux courroies de transport sans fin (26, 28) qui forment les parois latérales, dans lequel les ouvertures d'injection de gaz (18, 24) sont positionnées entre les deux zones latérales (36, 38), de sorte que, lors de l'utilisation, du gaz injecté dans le tunnel de procédé (12) via les ouvertures d'injection de gaz (18, 24) s'écoule substantiellement latéralement vers les zones latérales (36, 38) et s'échappe via les ouvertures d'échappement de gaz (30).

9. Appareil de traitement de substrat selon la revendication 8, dans lequel les zones latérales (36, 38) présentent chacune une largeur latérale inférieure à 2 mm.

10. Appareil de traitement de substrat selon l'une quelconque des revendications 1-9, comprenant :
• plusieurs vannes de contrôle (40) via lesquelles les ouvertures d'injection de gaz (18, 24) peuvent être connectées à des sources de gaz (44, 46, 48) ;
• un dispositif de contrôle électronique (50) qui est connecté en fonctionnement aux vannes de contrôle (40) ;
dans lequel le tunnel de procédé (12) inclut plusieurs sections longitudinales, dans lequel chaque section longitudinale s'étend latéralement sur la largeur entière du tunnel de procédé (12) et sur une partie de la longueur du tunnel de procédé (12), dans laquelle chaque section longitudinale est définie par les ouvertures d'injection de gaz (18, 24) dans le côté de tunnel plan dirigé vers le haut (22) et/ou côté de tunnel plan dirigé vers le bas (16) qui sont connectées via une des plusieurs vannes de contrôle (40) à une desdites sources de gaz (44, 46, 48),
dans lequel le dispositif de contrôle électronique (50) qui est connecté en fonctionnement aux vannes de contrôle (44, 46, 48) est configuré pour contrôler les vannes de contrôle (44, 46, 48) pour établir une pression moyenne de gaz dans chaque section longitudinale du tunnel de procédé (12).

11. Appareil de traitement de substrat selon la revendication 10, dans lequel le dispositif de contrôle électronique (50) qui est connecté en fonctionnement aux vannes de contrôle (40) est configuré pour contrôler les vannes de contrôle (40) pour établir une pression moyenne de gaz dans chaque section longitudinale du tunnel de procédé (12) de sorte que la pression moyenne de gaz dans le tunnel de procédé (12) diminue progressivement à partir d'une première pression moyenne de gaz à une extrémité longitudinale en amont (12') du tunnel de procédé jusqu'à une seconde pression moyenne de gaz à une extrémité longitudinale en aval (12") du tunnel de procédé, dans lequel la première pression moyenne de gaz est supérieure à la seconde pression moyenne de gaz.

12. Appareil de traitement de substrat selon l'une quelconque des revendications 1-11, dans lequel une ligne centrale de tunnel de procédé (C) est définie par une ligne qui s'étend à des distances égales par rapport aux deux parois latérales (26a, 28a) et à des distances égales au côté de tunnel plan dirigé vers le bas (16) et au côté de tunnel plan dirigé vers le haut (22), dans lequel le boîtier est disposé de sorte que la ligne centrale de tunnel de procédé (C) inclut un angle léger (α) avec un plan horizontal de sorte qu'une extrémité en amont du tunnel de procédé se trouve à un niveau plus élevé qu'une extrémité en aval du tunnel de procédé, dans lequel l'angle léger (a) est de 0° à 5°.

13. Procédé pour le traitement de substrats comprenant :
• la fourniture d'un appareil de traitement de substrat (10) selon l'une quelconque des revendications 1-12 ;
• l'introduction intermittente de substrats (S) dans le tunnel de procédé (12) à une extrémité en amont (12') de celui-ci et le déchargement intermittent des substrats (S) du tunnel de procédé (12) à une extrémité en aval (12") de celui-ci et le logement simultané de plusieurs substrats substantiellement plats (S) dans le tunnel de procédé (12) et la mise sur support de manière flottante des plusieurs substrats (S) avec les supports de gaz supérieur et inférieur ;
• le déplacement de chaque substrat (S) des plusieurs substrats avec une vitesse de transport de substrat (Vₛ) à travers le tunnel de procédé (12) le long de sa direction longitudinale ;
• l'actionnement des deux courroies de transport sans fin (26, 28) avec une vitesse de courroie (V_{b}) de sorte que les parties (26a, 28a) qui forment les parois de côtés latéraux présentent une vitesse de courroie (V_{b}) qui est substantiellement identique à la vitesse de transport de substrat (V_{S}).
